Europäisches Patentamt

European Patent Office

Office européen des brevets

(19)

(11) Veröffentlichungsnummer: **0 258 691**
**A2**

(12) **EUROPÄISCHE PATENTANMELDUNG**

(21) Anmeldenummer: **87111582.0**

(22) Anmeldetag: **10.08.87**

(51) Int. Cl.³: **H 02 J 7/14**

(30) Priorität: **03.09.86 DE 3629987**

(43) Veröffentlichungstag der Anmeldung:
**09.03.88 Patentblatt 88/10**

(84) Benannte Vertragsstaaten:
**DE FR GB IT**

(71) Anmelder: **HÜCO GmbH**
**Postfach 12 28 Von dem Bussche-Münch-Strasse 12**
**D-4992 Espelkamp(DE)**

(72) Erfinder: **Sasten, Gerd-Udo**
**Spechtstrasse 34**
**D-4992 Espelkamp(DE)**

(54) **Spannungsregler für Generatoren.**

(57) Für einen Spannungsregler für Generatoren von Kraftfahrzeugen wird vorgeschlagen, die Spannungsreglerschaltung in der Art einer Hybridschaltung auf einer sandwichartigen Trägerplatte anzuordnen. Dabei weist die Trägerplatte einen gut wärmeleitenden, metallischen Kern auf und ist mit einem isolierenden Überzug versehen, auf dem wiederum die Leiterbahnen der Hybridschaltung aufgebracht/aufgedruckt sind.

Fig.1

EP 0 258 691 A2

0258691

HÜCO GmbH

Von dem Bussche-Münch-Str. 12

D-4992 Espelkamp

7.08.1987
Sa/Li

Spannungsregler für Generatoren

Die Erfindung betrifft einen Spannungsregler für Generatoren, insbesondere zur Verwendung in Kraftfahrzeugen, welcher mit einer einen Leistungshalbleiter ansteuernden elektronischen Schaltung versehen ist, wobei durch entsprechende Ansteuerung des Leistungshalbleiters dessen Schaltstrecke die abgegebene Generatorspannung an die erforderliche Batterieladespannung anpaßt, und wobei der Leistungshalbleiter auf einem gut wärmeleitenden Träger aus metallischem Werkstoff angeordnet ist und vom Träger isoliert Leiterbahnen zur Verbindung des Leistungshalbleiters mit den Bauelementen der elektronischen Schaltung vorgesehen sind.

Derartige Spannungsregler sollen klein, kompakt und unempfindlich gegen Stöße und Vibrationen sein. Zur Vermeidung von langen Verbindungsleitungen sollen derartige Spannungsregler direkt an dem Generator anbringbar sein. Darüber hinaus ist es erforderlich, daß solche Spannungsregler in einem weiten Temperaturbereich uneingeschränkt stabil arbeiten.

Es ist bekannt, die Spannungsregler-Schaltung auf einem Keramiksubstrat oder einer herkömmlichen Leiterplatte (z.B. Epoxydharzgewebe) anzuordnen.

Zur Ableitung der in den Leistungshalbleitern der Schaltung entstehenden Wärme ist es bei Spannungsregler-Schaltungen, die auf einen Keramiksubstrat angeordnet sind, bekannt,
   a) den/die Leistungshalbleiter an einem Kühlblech bzw. Kühlkörper zu befestigen und der elektrische Anschluß zu den Lötpunkten auf dem Keramiksubstrat erfolgt direkt über die Anschlußbeine der Halbleiters bzw. über zwischengeschaltete Kabelverbindungen, und oder

b) den/die Leistungshalbleiter direkt auf vorgegebene Lötflächen des Keramiksubstrates zu löten, wobei das Keramiksubstrat dann mit seiner Unterseite an einem Kühlblech bzw. Kühlkörper - z.B. durch Klebung - befestigt wird.

Bei Spannungsregler-Schaltungen mit Leistungsbauelementen, die auf herkömmlichen Leiterplatten angeordnet sind, ist es bekannt, zur Ableitung der in den Leistungsbauelementen entstehenden Wärme, diese an ein Kühlblech zu montieren.

Diese bekannten Anordnungen arbeiten im großen und ganzen zufriedenstellend, sind jedoch vom Aufbau her gesehen aufwendig und aus mehreren, teilweise schwierig zu montierenden Einzelteilen aufgebaut. Darüber hinaus treten bei den bekannten Anordnungen häufig Störungen/Ausfälle duch hohe thermische Belastungen der Bauelemente bzw. deren Anschlüsse auf.

Der Erfindung liegt nunmehr die Aufgabe zugrunde, einen Spannungsregler der eingangs genannten Art dahingehend auszubilden, daß dieser äußerst kompakt aufgebaut ist und nur aus einer geringen Anzahl von einfach zu montierenden Teilen besteht, wobei auch die thermische Belastung der Bauteile und deren Anschlüsse gering gehalten werden soll.

Diese Aufgabe wird dadurch gelöst, daß die gesamte Schaltung des Spannungsreglers einschließlich des Leistungshalbleiters auf einem Träger aus flachem, gut wärmeleitendem Material angeordnet ist, wobei der Träger mit einem homogenen, elektrisch nicht leitenden Überzug versehen ist, auf dem die Leiterbahnen zum leitenden Träger hin isoliert, in der Art einer an sich bekannten gedruckten Schaltung aufgebracht sind, und daß der Leistungshalbleiter sowie die Bauelemente der elektronischen Schaltung und die Anschlußpfosten in thermisch innigen Kontakt, jedoch isoliert auf dem Träger bzw. dem Überzug angeordnet und gelötet sind.

Weitere vorteilhafte Ausgestaltungen der Erfindung sind in den Ansprüchen 2 - 8 angegeben.

Die mit der Erfindung erzielten Vorteile bestehen insbesondere darin, daß durch die Ausbildung der Trägerplatte als Schaltungsträger und als Kühlblech bzw. Kühlkörper für den/die Leistungshalbleiter, die Anzahl der zu montierenden Bauteile reduziert wird und sich dabei die Montage äußerst einfach und kostengünstig vornehmen läßt.

Daneben besteht der Vorteil der erfindungsgemäßen Ausgestaltung des Spannungsreglers darin, daß dadurch, daß alle Bauelemente auf einem gemeinsamen, gut wärmeleitenden Träger angeordnet sind, diese sich bei Erwärmung des Träger - z. B. bei Wärmeabgabe der Leistungsbauelemente - gleichmäßig mit erwärmen.

Es wird eine gleichmäßige Wärmeverteilung über die gesamte Baugruppe erzielt, wodurch sich die thermischen Belastungen für die verschiedenen Bauelemente, deren Lötstellen und den Schaltungsträger erheblich verringern. Dadurch bedingt wird eine hohe Funktionssicherheit über längere Funktionsdauer erzielt, wobei sich außerdem die komplette Schaltung in ihrem Temperaturverhalten günstig abstimmen läßt.

Ein weiterer Vorteil der Erfindung ist dadurch gegeben, daß der Träger aus metallischem Material mit als Gehäuseteil genutzt werden kann. Das ermöglicht eine Montage, bei der der Träger mit einer Seite auf dem Gehäuseteil aufliegt. Hierbei wird dann entweder die abgebbare Verlustleistung und somit die max. zulässige Schaltleistung des Reglers beträchtlich erhöht (es können höhere Leistungen / Ströme geschaltet werden) oder es kann ein kleinerer Transistortyp in die Schaltung eingesetzt werden.

Ein Ausführungsbeispiel der Erfindung ist in der Zeichnung dargestellt und wird im folgenden näher beschrieben. Es zeigen:

Fig. 1    die Ansicht des mechanischen Aufbaus eine Spannungsreglers, und

Fig. 2    die Seitenansicht des Spannungsreglers gem. Fig. 1

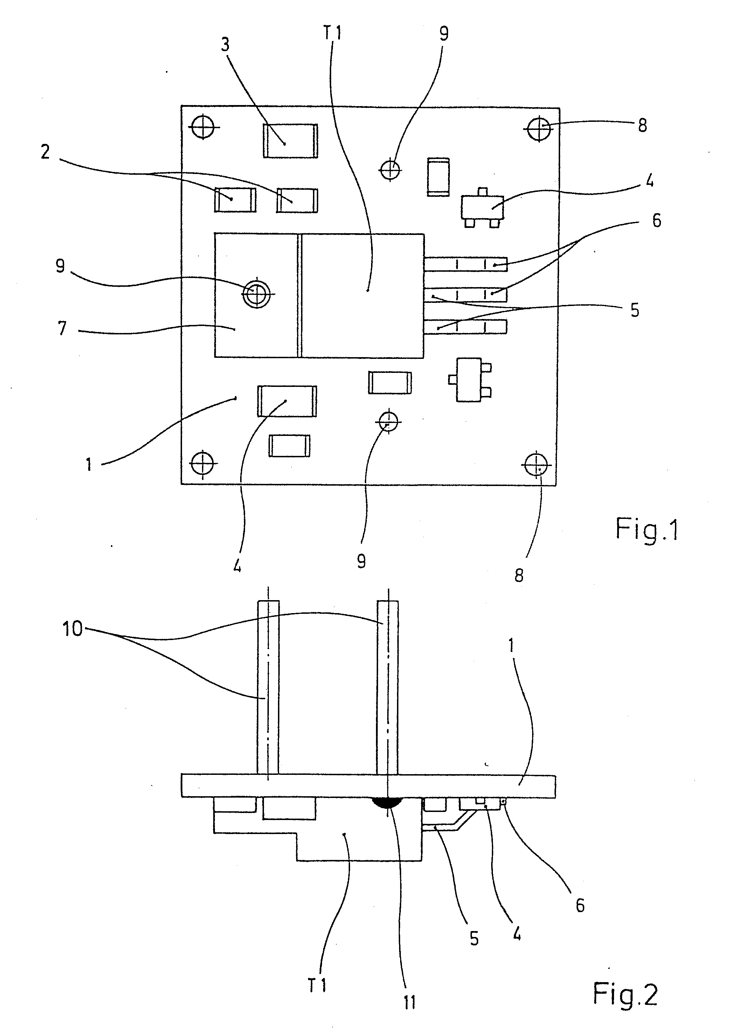

Der in den Fig. 1 und 2 dargestellte Spannungsregler besteht im wesentlichen aus einer Trägerplatte 1 auf der eine Hybridschaltung, d.h. eine an sich bekannte Schaltungsanordnung mit gedruckten Leiterbahnen und darauf aufgelöteten Subminiaturbauelementen wie Widerstände 2, Kondensatoren 3, Halbleitern 4 und einem Leistungstransistor T1, angeordnet ist.

Selbstverständlich können dabei auch die Widerstände, ähnlich wie die Leiterbahnen drucktechnisch aufgebracht werden.

Dabei ist es dann auch zusätzlich möglich, diese Widerstände mittels geeigneter Einrichtungen wie Laserstrahl, Sandstrahl etc. abzugleichen, d.h. auf einem bestimmten Sollwert zu bringen und die komplette Schaltung funktionsmäßig optimal abzustimmen.

Die Trägerplatte 1 besteht aus einem gut wärmeleitenden Material, z.B. Stahl, Aluminium, Kupfer o.ä. und ist mit einem allseitigen, dünnen, jedoch mechanisch stabilen, homogenen Überzug versehen. Auf diesem Überzug sind die Leiterbahnen für die Hybridschaltung aufgebracht. Da der Überzug isolierende Eigenschaften aufweist, sind die Leiterbahnen gegen den Metallkern der Trägerplatte elektrisch isoliert. Andererseits ist der Überzug so dünn ausgebildet, daß die thermische Isolation zwischen den auf der Oberseite der Trägerplatte aufgebrachten Bauelementen, insbesondere dem Leistungshalbleiter und dem metallischen Kern der Trägerplatte sehr gering ist.

Daher wird in den Bauelementen entstehende Wärme, insbesondere die Verlustwärme des Leistungshalbleiters T1 in die Trägerplatte abgeleitet und von deren relativ großer Oberfläche an die Umgebungsluft abgegeben. Zur besseren Wärmeleitung kann die Trägerplatte natürlich wiederum an eine als Kühlfläche wirkende Wandfläche, Gehäusefläche o.ä. montiert sein.

Der Leistungstransistor T1 der hier im Ausführungsbeispiel die Gehäuseform TO-220 aufweist, ist mit abgewinkelten Anschlußfahnen 5 versehen und deren Enden 6 sind mit den Leiterbahnen auf der Trägerplatte verlötet. Dabei ist diese Abwinklung der Anschlußfahnen und die Montage des Transistors so vorgenommen, daß der Transistor mit der Montagefläche 7 seines Gehäuses auf eine vorgesehene Leiterbahnfläche gelötet wird und dabei in thermisch innigem Kontakt mit dem Kern der Trägerplatte steht. Es lassen sich somit alle Bauelemente in gemeinsamen Verfahrensschritten bei Herstellungsablauf automatisch bestücken und löten.

Zur mechanischen Befestigung der Trägerplatte 1 und somit des kompl. Spannungsreglers an den dafür vorgesehenen Einrichtungen (Gehäuse, Halter, etc.) sind entsprechende Bohrungen 8 vorhanden.

Der elektrische Anschluß der Schaltung erfolgt in dem Ausführungsbeispiel über Anschlußpfosten 10. Die Anschlußpfosten 10 die einen gestauchten Kopf 11 besitzen, werden von der Bauteilseite durch entsprechende Aussparungen 9 der Trägerplatte 1 gesteckt und verlötet.

Dabei sind die Aussparungen entweder genügend groß bemessen, so daß die Anschlußpfosten auf keinen Fall mit dem elektrisch leitfähigen Kern der Trägerplatte in Berührung gelangen, oder es ist vorgesehen, daß die Aussparungen vor dem Aufbringen der Isolierung der Trägerplatte in diese eingebracht werden, und somit die inneren Wandungen der Ausnehmungen ebenfalls mit einem isolierenden Überzug versehen werden, so daß elektr. Kurzschlüsse zwischen den Anschlußfosten 10 bzw. Verbindungen zum leitenden Kern der Trägerplatte mit Sicherheit verhindert werden.

Auf die elektrische Wirkungsweise eines solchen Spannungsreglers soll hier nicht näher eingegangen werden, die diese Schaltungen allgemein bekannt sind.

Zusammenfassend sei nochmals erwähnt, daß durch die kombinierte Anwendung der sandwichartigen Trägerplatte 1 als Schaltungsträger und als Kühlblech bzw. Kühlkörper sich produktionstechnisch und kostenmäßig gesehen erhebliche Vorteile gegenüber den bekannten Anordnungen ergeben.

- 6 -                                              0258691

HÜCO GmbH

Von dem Bussche-Münch-Str. 12

D-4992 Espelkamp                                    07.08.1987
                                                   Sa/Li.


Spannungsregler für Generatoren

<u>Patentansprüche</u>


1. Spannungsregler für Generatoren, insbesondere zur Verwendung in Kraftfahrzeugen, welcher mit einer einen Leistungshalbleiter ansteuernden elektronischen Schaltung versehen ist, wobei durch entsprechende Ansteuerung des Leistungshalbleiters dessen Schaltstrecke die abgegebene Generatorspannung an die erforderliche Batterieladespannung anpaßt, und wobei der Leistungshalbleiter auf einem gut wärmeleitenden Träger aus metallischem Werkstoff angeordnet ist und vom Träger isoliert Leiterbahnen zur Verbindung des Leistungshalbleiters mit den Bauelementen der elektronischen Schaltung vorgesehen sind, dadurch gekennzeichnet,
daß der Träger (1) mit einem homogenen, elektrisch nicht leitenden Überzug versehen ist, auf dem die Leiterbahnen zum leitenden Träger (1) hin isoliert, in der Art einer an sich bekannten gedruckten Schaltung aufgebracht sind, und daß der Leistungshalbleiter (T1) sowie die Bauelemente (2,3,4) der elektronischen Schaltung und die Anschlußpfosten in thermisch innigen Kontakt, jedoch isoliert auf dem Träger (1) bzw. dem Überzug angeordnet und gelötet sind.

2. Spannungsregler nach Anspruch 1, dadurch gekennzeichnet, daß der Überzug aus einem Keramikmaterial besteht.

3. Spannungsregler nach Anspruch 1, dadurch gekennzeichnet, daß der Überzug durch eine Emaillierung des Trägers gebildet wird.

0258691

4. Spannungsregler nach Anspruch 1, dadurch gekennzeichnet,
daß der Überzug des Trägers durch Eloxierung des Trägers ausgebildet
wird.

5. Spannungsregler nach einem der vorstehenden Ansprüche, dadurch gekennzeichnet,
daß der Träger Bohrungen bzw. Durchbrüche aufweist.

6. Spannungsregler nach Anspruch 5, dadurch gekennzeichnet,
daß die Bohrungen/Durchbrüche auf ihren inneren Wandungen ebenfalls
mit einem elektrisch isolierenden Überzug versehen sind.

7. Spannungsregler nach einem oder mehreren der vorstehenden Ansprüche,
dadurch gekennzeichnet,
daß zwischen ausgewählten Punkten der Leiterbahnen elektrische Widerstände durch aufgedruckte Widerstandspaste ausgebildet sind.

8. Spannungsregler nach einem oder mehreren der vorstehenden Ansprüche,
dadurch gekennzeichnet,
daß der Träger mit zusätzlichen Kühlrippen versehen ist.

C258691

1/1

Fig.1

Fig.2